# EUROPEAN PATENT APPLICATION

(11) **EP 1 693 117 A2**
(43) Date of publication of application: **23.08.2006**
(21) Application number: 06001286.1
(22) Date of filing: 21.01.2006
(51) Int. Cl.: B05C 11/10

(54) **Deposition device having a thermal control system**

(30) Priority: 18.02.2005 US 906406
(71) Applicant: NORDSON CORPORATION, Westlake, Ohio 44145-1119 (US)
(72) Inventor: Forti, Michael S., Franklin, Massachusetts 02038 (US); Vivari Jr., John A., Greenville, Rhode Island 02828 (US)
(74) Representative: Eisenführ, Speiser & Partner

(57) **Abstract**

An apparatus for depositing a material onto a substrate under thermally controlled conditions includes an enclosure (64) defining an interior (68) and having an opening (84), and a deposition device (10) having an orifice (12) and capable of depositing the material (14) onto the substrate (16). The deposition device (10) is positioned within the interior (68) and the opening (84) allows the orifice (12) to communicate with an environment outside the enclosure (64). The apparatus further includes a thermal control unit (66) operatively coupled with the enclosure (64). The thermal control unit (66) includes a vortex tube (86) having an inlet (90) adapted to be coupled with a pressurized gas supply (92), a cold gas outlet (98) in fluid communication with the interior (68) and adapted to deliver cold gas thereto, and a hot gas outlet (100) also in fluid communication with the interior (68) and adapted to deliver hot gas thereto. The cold and hot gases from the vortex tube (86) are adapted to control the temperature of the deposition device (10).

## Description

### Field of the Invention

This invention generally relates to material deposition processes, and more particularly to a thermal control system for controlling the temperature of the material deposition process.

### Background of the Invention

Material deposition processes are commonly used in a wide range of industrial applications, such as in the manufacture of electrical, electromechanical, and mechanical assemblies. In many applications, it is desirable that assembly fluids, including but not limited to, greases, lubricants, inks, sealants, epoxies, adhesives, solder pastes, cyanoacrylates, under-fills, encapsulants, thermal compounds, and many other liquid and semi-liquid materials be applied to a substrate or working piece in a controlled and consistent manner. Fluctuations in material temperature and/or non-optimal operating temperatures commonly cause problems during the deposition process.

For example, the viscosity of a material is an important material property that significantly affects the overall quality and consistency of the deposition process. Viscosity is generally dependent on temperature, and is typically inversely related to temperature. Thus, as the operating temperature increases, the material becomes less viscous, and vice versa. In many deposition devices, pressure is often used to deposit a desired amount of material onto the substrate. This may be done, for example, by assuming an ideal operating temperature and determining a discharge pressure such that a known amount of material is deposited onto the substrate. If, for example, the actual operating temperature is higher than the ideal temperature, the viscosity of the material will be lower than expected and consequently more material will be deposited onto the substrate than desired. On the other hand, if the actual operating temperature is less than the ideal temperature, the viscosity of the material will be higher than expected and consequently less material will be deposited onto the substrate than desired. A variation in actual operating temperature of as little as 1-2°C, may cause significant changes in the consistency of the deposition process. Often, a change of this magnitude occurs naturally due to a change in temperature in the environment of the deposition process. For example, the temperature in many manufacturing facilities tends to fluctuate as the day progresses, generally being cooler in the nighttime hours and warmer in the daytime hours, which may cause a change in the actual operating temperature so as to affect the deposition process.

In addition to the viscosity variations, fluctuations in temperature and/or non-ideal operating temperatures may cause premature material degradation. For example, moderate to extreme temperature variations may cause some epoxies, adhesives, or other curable materials to start setting. Additionally, one or more constituents of a multi-constituent material, such as metal particulate in solder paste, may begin to fall out of solution under such conditions. For these and other reasons, it is desirable to control and maintain the temperature of the deposition process.

Several methods have been used to control the temperature of the material deposition process. For example, manufacturers will often condition the air in the entire manufacturing area or within a particular piece of equipment. Building air conditioning, however, is costly to purchase, maintain, and operate and also allows a substantial change in temperature between the building and the area local to the deposition device, which often includes heat-generating components, such as lights, motors, computers, fans, etc. Building air conditioning units are also slow to respond to changes in temperature, taking perhaps several hours to effectuate localized temperature changes. Current trends in the electronic industry tend towards large, expensive thermal control devices designed to maintain an entire piece of equipment at a set point temperature. These devices, however, are also costly to purchase, maintain and operate and take up considerable floor space. As the space being thermally controlled is also relatively large, these thermal control devices are also slow to respond to thermal changes within the machine.

Some point source heating or cooling systems are also known in the art. Peltier thermoelectric devices, for example, have been used to cool electrical components, such as chips and computers. To this end, the Peltier device is typically directly connected to a bearing surface of a component and heats or cools the component through conduction. These devices, however, have several drawbacks including requiring custom enclosures and setups and irregular temperature control across the component. Moreover, the direct connection between the Peltier device and the component may make assembly and disassembly, such as during maintenance and repair, more costly and time consuming.

Other heating and cooling systems, such as water-based systems, are also known. These systems are usually undesirable because of the hazards posed by the presence of water, or other liquids, in the system in the event of a leak. In addition, water-based systems also require a heat sink (e.g. fan blowing air over a bank of fins), which limits the amount of available cooling. These systems further require custom setups and are costly to operate and maintain.

Accordingly, there is a need for a deposition device having an improved thermal control system for controlling the temperature of a deposition device so that a material may be deposited onto a substrate in a controllable and consistent manner.

### Summary of the Invention

The invention provides an apparatus for depositing a material onto a substrate under thermally controlled conditions. The apparatus includes an enclosure defining an interior and having an opening, and a deposition device having an orifice and capable of depositing the material onto the substrate. The deposition device is positioned within the interior of the enclosure and the opening is adapted to allow the orifice to communicate with an environment outside the enclosure. The apparatus further includes a thermal control unit operatively coupled with the enclosure to provide heating and cooling to the enclosure interior. The thermal control unit includes a vortex tube adapted to generate cold and hot gas streams from a pressurized gas supply. The vortex tube includes an inlet adapted to be coupled with the pressurized gas supply, a cold gas outlet in fluid communication with the interior and adapted to deliver the cold gas thereto, and a hot gas outlet also in fluid communication with the interior and adapted to deliver the hot gas thereto. The cold and hot gases from the vortex tube are adapted to control the temperature of the deposition device.

The thermal control unit may include additional components to control the flow of gas to the interior of the enclosure. For example, an outlet valve may be coupled with at least one of the cold and hot gas outlets. The outlet valve is operable to vary the flow of gas delivered to the interior of the enclosure through the cold and/or hot gas outlets. In one embodiment, a first outlet valve is coupled with the cold gas outlet and a second outlet valve is coupled with the hot gas outlet. The first and second outlet valves may be, for example, solenoid valves that port cold or hot gas either to the interior of the enclosure or to an environment outside the enclosure. The thermal control unit may also include a controller operatively coupled with the outlet valve to actuate the outlet valve so as to control the flow of gas to the interior. An inlet valve may also be coupled with the inlet to the vortex tube and operable to vary the flow of gas delivered thereto. The controller may be operatively coupled with the inlet valve so as to control the flow of gas to the vortex tube. A temperature-sensing device may be operatively coupled with the controller and adapted to communicate a temperature associated with the deposition device to the controller.

The apparatus described above may be used to thermally control a material deposition process. To this end, the deposition device is positioned in the interior of the enclosure. The deposition device includes an orifice and is capable of depositing a material onto a substrate. In operation, the temperature-sensing device measures a temperature associated with the deposition device. Based on the measured temperature, at least one of the cold or hot gases from the vortex tube is delivered to the interior of the enclosure so as to cool or heat the deposition device. To this end, and in an exemplary embodiment of the invention, a desired operating temperature is stored in the controller. The desired operating temperature may be a single desired temperature or may be a desired temperature range. For instance, the controller may include an input device for a user to manually input the desired operating temperature. In one mode of operation, cold gas is delivered to the interior of the enclosure. When the measured temperature associated with the deposition device drops below the desired operating temperature, the flow of cold gas is turned off, the hot gas is turned on and hot gas is delivered to the interior of the enclosure. When the measured temperature associated with the deposition device goes above the desired operating temperature, the flow of hot gas is turned off, the cold gas is turned on and cold gas is once again delivered to the interior of the enclosure. By repeating these steps, the temperature of the material deposition process is maintained substantially at the desired operating temperature.

In another embodiment of the invention, a thermal control system for a deposition device having an orifice and capable of depositing a material onto a substrate is provided. The thermal control system includes an enclosure defining an interior for containing the deposition device and has an opening adapted to allow the orifice to communicate with an environment outside the enclosure. To this end, the thermal control system further includes a thermal control unit operatively coupled with the enclosure to provide heating and cooling to the enclosure interior. The thermal control unit includes a vortex tube adapted to generate cold and hot gas streams from a pressurized gas supply. The vortex tube includes an inlet adapted to be coupled with the pressurized gas supply, a cold gas outlet in fluid communication with the interior and adapted to deliver the cold gas thereto, and a hot gas outlet in fluid communication with the interior and adapted to deliver the hot gas thereto.

In yet another embodiment of the invention, a thermal control unit adapted to provide heating and cooling to an enclosure containing a deposition device is provided. The thermal control unit includes a vortex tube adapted to generate cold and hot gas streams from a pressurized gas supply. The vortex tube includes an inlet adapted to be coupled with the pressurized gas supply, a cold gas outlet in fluid communication with the enclosure and adapted to deliver the cold gas thereto, and a hot gas outlet in fluid communication with the enclosure and adapted to deliver the hot gas thereto. The thermal control unit also includes an outlet valve coupled with at least one of the cold and/or hot gas outlets and is operable to vary the flow of gas delivered to the enclosure through the cold and/or hot outlets. A controller is operatively coupled with the outlet valve and adapted to actuate the outlet valve so as to control the flow of gas to the enclosure. A temperature-sensing device is operatively coupled with the controller and adapted to communicate a temperature associated with the deposition device to the controller.

These and other objects, advantages and features of the invention will become more readily apparent to those of ordinary skill in the art upon review of the following detailed description taken in conjunction with the accompanying drawings.

### Brief Description of the Drawings

The accompanying drawings, which are incorporated in and constitute a part of this specification, illustrate embodiments of the invention and, together with a general description of the invention given above, and the detailed description given below, serve to explain the invention.

Fig. 1 illustrates an exemplary embodiment in accordance with the invention with a deposition device in the form of a dispensing valve;

Fig. 2 illustrates an exemplary embodiment in accordance with the invention with a deposition device in the form of a dispensing syringe; and

Fig. 3 illustrates an exemplary embodiment of a thermal control unit in accordance with the invention.

### Detailed Description

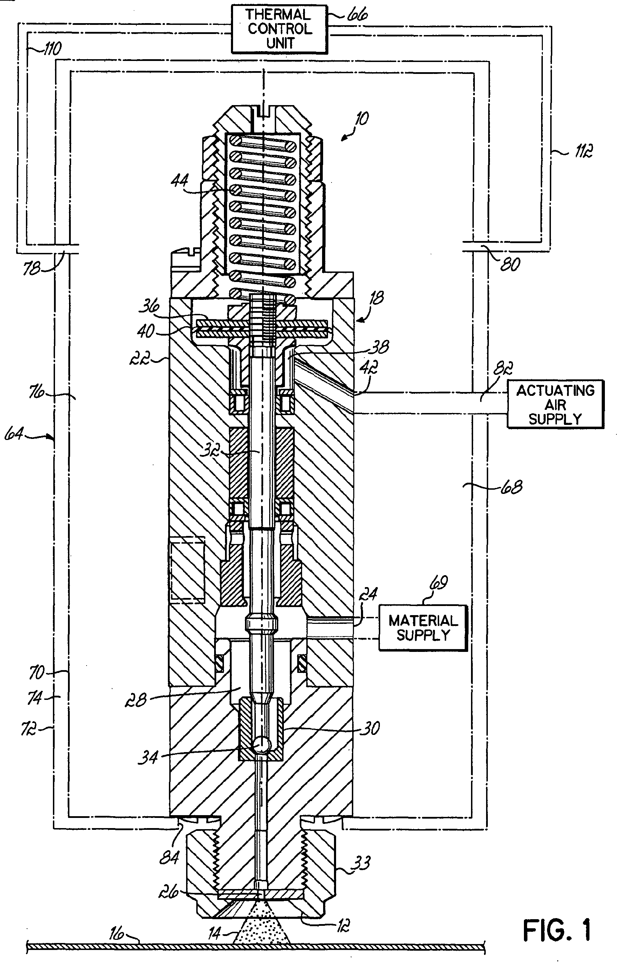

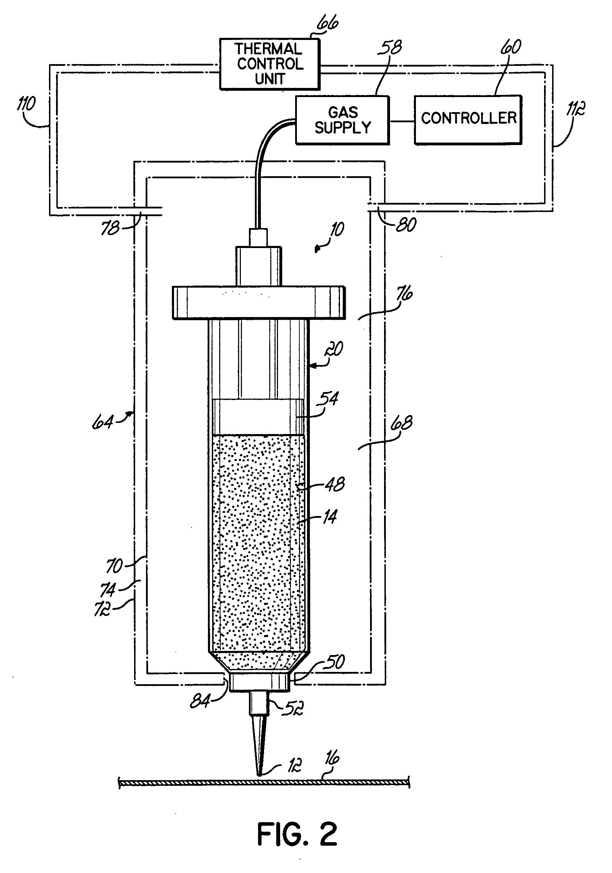

As shown in Figs. 1 and 2, a material deposition process generally includes a deposition device 10 having an orifice 12 capable of depositing a material 14 onto a substrate 16 positioned adjacent or in a spaced relation to orifice 12. While the invention is not limited to a particular type of deposition device, for illustrative purposes, the deposition device 10 may be a dispensing valve 18, as generally shown in Fig. 1, or a dispensing syringe 20, as generally shown in Fig. 2. Those of ordinary skill in the art, however, will recognize other deposition devices 10 that may be used with the invention. For example, deposition devices such as cartridges, tubes, enclosed heads for printing processes, and other devices known in the art may be used in the invention. Moreover, deposition, as used herein, generally means the placement of a liquid or semi-liquid material onto a substrate without limitation on how the placement or deposit of material is accomplished. For instance, deposition through daubing, dispensing, printing, and other processes are contemplated to be within the scope of the invention. Moreover, dispensing includes bead dispensing, dot dispensing, spraying, jetting and other types of dispensing.

An illustrative dispensing valve 18 is shown in Fig. 1 and includes a dispenser body 22, a material inlet 24, an outlet 26, and a flow channel 28 between the material inlet 24 and the outlet 26 capable of directing a flow of the material 14. The flow channel 28 includes a valve seat 30 near the outlet 26. A valve stem 32 is mounted in dispenser body 22 for reciprocating motion therein. The valve stem 32 includes a valve element, such as ball 34, that cooperates with valve seat 30 to selectively discharge material 14 from dispensing valve 18. In particular, the valve stem 32 reciprocates between an open and closed position. In the open position, ball 34 is disengaged from the valve seat 30 so that a gap is formed therebetween that allows material 14 to be discharged from outlet 26. In the closed position, ball 34 is engaged with the valve seat 30 so as to prevent any material 14 from being discharged from the outlet 26. Movement of the valve stem 32 between the open and closed positions then controls the discharging of material from dispensing valve 18. A valve nozzle 33 defining orifice 12 may be coupled with dispensing valve 18 adjacent outlet 26 for effecting the flow of material 14 prior to deposition onto substrate 16.

Dispensing valve 18 further includes an actuator operatively coupled with valve stem 32 and capable of actuating the valve stem 32 between the open and closed positions so as to selectively discharge material 14 from the outlet 26. In the exemplary embodiment, the actuator includes a piston 36 coupled with one end of valve stem 32 and is positioned within air passage 38 so that a bottom surface of piston 36 closes off the air passage 38 and is sealed by piston seal 40. Pressurized air may be introduced into air passage 38 through an air inlet 42 to move piston 36 and therefore valve stem 32 upward and out of engagement with valve seat 30 to allow material flow out of outlet 26. The actuator may also include a spring-return mechanism operatively coupled with valve stem 32 and configured to urge piston 36 and thus valve stem 32 downward into engagement with valve seat 30. To this end, when air passage 40 is depressurized, a spring 44 applies a downward force to engage ball 34 with valve seat 30 to prevent material flow from outlet 26. Those having ordinary skill in the art will recognize other configurations for the actuator. For instance, instead of, or in addition to, a spring-return mechanism, a double acting piston with air passages on both sides of the piston may be used. Alternately, electrical actuators may be used to selectively move the valve stem 32 between open and closed positions.

The invention is not limited to dispensing valves as described above, as those of ordinary skill in the art will recognize other types of deposition valves that deposit material onto a substrate in a different manner. For instance, deposition valves for depositing highly viscous materials, such as solder paste, may use a rotating auger to deposit materials onto a substrate. These devices are contemplated to be within the scope of the invention. A wide variety of deposition valves are commercially available from EFD Inc. of East Providence, Rhode Island under, for example, their 740V Series, 725D Series, 752V Series, and 790 Series of valves.

As shown in Fig. 2, the deposition device 10 may alternately take the form of dispensing syringe 20. Dispensing syringe 20 generally includes a tubular syringe barrel 46 having an interior adapted to operate as a reservoir 48 for a material 14 that is to be discharged from the syringe 20. A first end 50 of the syringe barrel 46 has a connecting member, such as threads, so that a syringe tip 52, defining orifice 12, may be coupled with the first end 50. A wide variety of syringe tips 52 may be coupled with first end 48 depending on the particular application and desires of the user. The dispensing syringe 20 further includes a plunger 54 adjacent a second end 56 of barrel 46. The plunger 54 acts on the material 14 in reservoir 48 so as to discharge the material 14 through the syringe tip 52 and onto substrate 16. The plunger 54 may be actuated in a variety of ways. For instance, a stem (not shown) may be coupled with plunger 54 and extend from second end 56 so that a user may manually depress the stem and plunger 54 to discharge the material 14. Alternately, and as shown schematically in Fig. 2, the second end 56 of barrel 46 may be coupled with a pressurized gas supply 58, such as compressed air, for actuating plunger 54. A controller 60 may be coupled with gas supply 58 for controlling the pressurized gas and thus providing controlled material dispensing from the syringe 20. Dispensing syringe systems as generally described above are commercially available from EFD Inc. of East Providence, Rhode Island under, for example, their Ultra™ 2400 Series or Ultra™ 1400 Series of dispensers. EFD also provides a wide variety of syringes 20 and syringe tips 54.

In accordance with the invention, a thermal control system 62 for controlling the temperature of the material deposition process includes an enclosure 64 and a thermal control unit 66 operatively coupled with the enclosure 64 and adapted to provide heating and cooling to the enclosure 64. Enclosure 64 defines an interior 68 into which deposition device 10, such as dispensing valve 18 or dispensing syringe 20, is contained. For some deposition devices 10, the material supply 69 which supplies material 14 to the deposition device 10, such as through inlet 24, is also preferably located within the enclosure 64 and coupled with deposition device 10 through suitable tubing. By way of example, material supply 69 may be a syringe, a pressure pot or other bulk container that operates as a reservoir for deposition device 10. Preferably, the enclosure 64 is a doubled wall chamber having an inner wall 70, outer wall 72 and an insulating gap 74 between inner and outer walls 70, 72. Insulating gap 74 is preferably filled with air or other suitable gases, provides a vacuum between the two walls, or alternately is filled with other low thermal conductivity materials. The double wall construction of the enclosure 64 is adapted to prevent heat transfer to or from the environment and thereby permit a more controlled thermal environment for the deposition process. The invention, however, is not so limited as a single wall construction may also be used in the invention.

In an exemplary embodiment, enclosure 64 may be made from a transparent material, such as Plexiglass, clear PVC or other structurally suitable materials. In this way, operators may visually observe the deposition device 10 within enclosure 64, which facilitates proper setup and operation of the deposition device 10. Additionally, at least for dispensing syringe 20, a transparent enclosure 64 allows an operator to see the amount of material 14 in reservoir 48 and refill the reservoir 48 prior to running out. The enclosure material may also be treated so as to have properties, such as anti-static or light blocking capabilities, which are advantageous in some applications. As one of ordinary skill in the art will recognize, the particular shape and size of enclosure 64 depends on the specific deposition device 10 being used in the material deposition process. Generally, however, the shape of enclosure 64 should be complementary to the shape of the deposition device 10 and provide a space 76 around deposition device 10 sufficient to allow heating and cooling as needed. For example, the enclosure 64 must provide a space 76 around deposition device 10 to allow sufficient gas flow so as to meet the thermal control requirements.

Enclosure 64 may include a cold gas inlet port 78 and a hot gas inlet port 80, each in fluid communication with the interior 68 of enclosure 64 and adapted to receive cold and hot gas, respectively, from the thermal control unit 66, as will be discussed in detail below. The enclosure 64 may further include an actuating air inlet port 82 to deliver actuating air to the deposition device 10. As one of ordinary skill in the art will recognize, the enclosure 64 may include other inlets or outlets to accommodate the particular deposition device 10. For example, for a manually-actuated dispensing syringe, the enclosure may include an aperture for allowing a plunger stem to extend outside enclosure 64. Furthermore, for dispensing valve 18, when material supply 69 is positioned external to enclosure 64, enclosure 64 may include an aperture for delivering material 14 to inlet 24.

The deposition device 10 includes an orifice 12, such as the outlet of a syringe tip 52 or the outlet of a valve nozzle 33, in spaced relation with a substrate 16 and adapted to deposit material 14 onto substrate 16. To this end, enclosure 64 also includes an opening 84 that allows the orifice 12 of deposition device 10 to communicate with the environment outside of enclosure 64. For instance, the orifice 12 may be positioned inside enclosure 64 and material 14 may be deposited onto substrate 16 through opening 84. Alternately, as shown in Figs. 1 and 2, the orifice 12, such as the end portion of a valve nozzle 33 or syringe tip 52, may extend through the opening 84 to deposit material 14 onto substrate 16. Those of ordinary skill in the art will recognize a wide variety of deposition device/enclosure configurations that provide an opening 84 for depositing material 14 onto substrate 16.

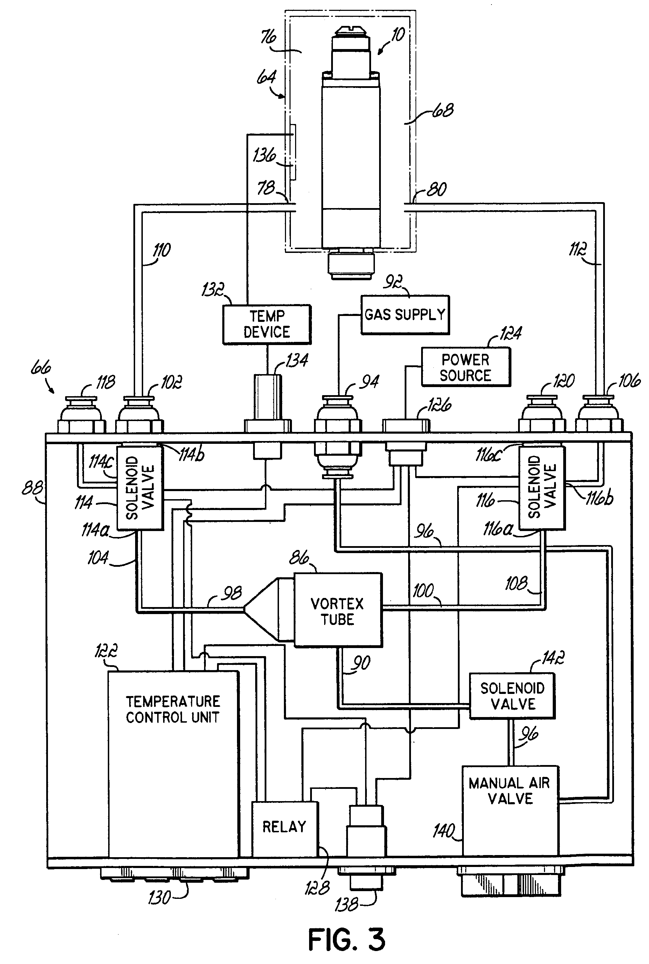

As shown in detail in Fig. 3, thermal control of the material deposition process is accomplished through thermal control unit 66, which is operatively coupled with enclosure 64 (shown schematically in Fig. 3) to provide heating and cooling to the interior 68 of enclosure 64. In particular, the thermal control unit 66 provides a stream of cold and hot gases to enclosure 64 so as to maintain the deposition device 10 at a desired operating temperature. Desired operating temperature, as used herein, means a single temperature, e.g. 70° F, or a temperature range, e.g. 65-72° F. For instance, in some applications, it may be desired that the deposition device 10 be kept at a single value, while in other applications a temperature range may be desirable. Both are within the scope of the invention and "desired operating temperature" is used to encompass both possibilities.

In order to provide both cold and hot gas streams to the interior 68 of enclosure 64, thermal control unit 66 includes a vortex tube, generally shown at 86. Vortex tubes have been in existence for a considerable amount of time and are generally known in the art. As such, only a brief discussion is included herein. A vortex tube accepts compressed gas at an inlet which is obliquely disposed with respect to the vortex tube body. The compressed gas enters the tube body at an angle and rapidly rotates helically towards one end. As a result of the rapid helical rotation of gas (for example at approximately one million revolutions per minute), a vortex is produced within the tube in which the inner region of rotating gas is expanding and compressing the outer region of rotating gas. Thus, the outer region of gas is acquiring heat from the inner region of rotating gas. At one end of the tube body, there is an opening that allows the hot, outer region of gas to be removed, thereby providing a hot gas output stream. The opposite end of the tube body also has an opening that allows the cold, inner region of gas to be removed, thereby providing a cold gas output stream. Commercially available vortex tubes can provide temperatures as low as -55°F at the cold end, or as high as 265°F at the hot end, which is well within desired operating temperatures in most industrial applications. Such vortex tubes useful for the invention may be obtained from suppliers such as Max Air of Fairfield, Ohio.

To this end, thermal control unit 66 includes a housing 88 with vortex tube 86 contained therein. Vortex tube 86 includes an inlet 90 that is coupled with a pressurized gas supply 92, such as a pressurized gas tank, a compressor, a pressurized gas supply line, or other pressurized gas supplies known in the art. While it is contemplated that pressurized air will be used with vortex tube 86, the invention is not so limited as other gases may also be used in the invention. The gas is preferably delivered to vortex tube 86 at not less than approximately 30 psi, and preferably at approximately 100 psi. Those of ordinary skill in the art will recognize, however, that a wide range of gas pressures may be used in the invention depending on the specific application and thermal requirements. Housing 88 may include a gas supply port 94, which is adapted to couple to gas supply 92 such as with an appropriate connector and tubing. Gas supply port 94 and inlet 90 to vortex tube 86 may then be coupled by inlet tubing 96.

Vortex tube 86 further includes a cold gas outlet 98 and a hot gas outlet 100 that receives the cold and hot gas, respectively, generated by the vortex tube 86. Housing 88 may include a cold gas port 102 coupled with cold gas outlet 98 via tubing 104 and a hot gas port 106 coupled with hot gas outlet 100 via tubing 108. Cold and hot gas ports 102, 106 are adapted to be coupled with cold and hot gas inlets 78, 80, respectively, so that cold and hot gas outlets 98, 100 are in fluid communication with the interior 68 of enclosure 64 and adapted to provide cold and hot gas thereto. For instance, a length of tubing 110, 112 may couple the cold and hot gas flows from thermal control unit 66 with enclosure 64. As recognized by those of ordinary skill in the art, the tubing associated with cold and hot gas (i.e., tubing 104, 108, 110, 112) is preferably made of low thermal conductivity plastic materials but may be made from a wide variety of materials. Additionally, the tubing may include insulation to reduce the heat transfer to/from the gas flows. Additional, many of the interior components of thermal control unit 66 may also be made of low thermal conductivity plastics, but is not so limited.

In order to control the temperature of the material deposition process, it may be necessary to control the flow of heated and/or cooled gas from vortex tube 86 and delivered to the interior 68 of the enclosure 64. To this end, thermal control unit 66 may include an outlet valve coupled with at least one of the cold or hot gas outlets 98, 100. In this way, the outlet valve operates to vary the flow of cold and/or hot gas delivered to enclosure 64 through the associated cold and/or hot gas outlets 98, 100. For instance, and as shown in Fig. 3, the thermal control unit 66 may include a first valve 114 coupled with cold gas outlet 98, such as in tubing 104 between cold gas outlet 98 and cold gas port 102. First valve 114 is operable to vary the flow of cold gas delivered to the interior 68 of enclosure 64. In a likewise manner, the thermal control unit 66 may also include a second valve 116 coupled with hot gas outlet 100, such as in tubing 108 between hot gas outlet 100 and hot gas port 106. Second valve 116 is operable to vary the flow of hot gas delivered to the interior 68 of enclosure 64. Those of ordinary skill in the art will recognize a wide range of valve configurations that might be used in the invention to vary the flow of cold and/or hot gas to enclosure 64. For instance, only one valve coupled with either one or both cold and hot gas outlets 98, 100 may be used. These various configurations are contemplated to be within the scope of the invention.

By way of example, and as shown in Fig. 3, first and second valves 114, 116 may be solenoid valves that are moveable or actuable between a gas feeding position and an exhaust position. To this end, and with reference to valve 114, valve 114 may have a single valve inlet 114a and two valve outlets 114b, 114c. When valve 114 is in the gas feeding position, valve inlet 114a is in fluid communication with valve outlet 114b, which is coupled with cold gas port 102. When the valve 114 is in the exhaust position, valve inlet 114a is in fluid communication with valve outlet 114c, which is coupled with a cold gas exhaust port 118 on housing 88. Cold gas exhaust port 118 is not in fluid communication with the interior 68 of enclosure 64, but instead ports the cold gas to an environment outside of enclosure 64. Valve 116 operates in a similar manner. Thus, when valve 116 is in the gas feeding position, valve inlet 116a is in fluid communication with valve outlet 116b, which is coupled with hot gas port 106. When the valve 116 is in the exhaust position, valve inlet 116a is in fluid communication with valve outlet 116c, which is coupled with a hot gas exhaust port 120 on housing 88. Hot gas exhaust port 120 is not in fluid communication with the interior 68 of enclosure 64, but instead ports the hot gas to an environment outside of enclosure 64. The invention is not limited to solenoid valves, as other valves known in the art may be used with the invention.

Thermal control unit 66 may further include a controller 122 operatively coupled with the outlet valve, or as shown in Fig. 3, with first and second outlet valves 114, 116. Controller 122 is configured to actuate first and second valves 114, 116 so as to control the flow of gas to the interior 68 of the enclosure 64. In particular, controller 122 is configured to actuate first and second valves 114, 116 so as to keep the deposition device 10 at the desired operating temperature. For example, controller 122 may be a digital controller electrically coupled with a power source 124 and further electrically coupled with the valves 114, 116 via suitable electrical wiring. Housing 88, for example, may include an electrical adaptor 126 adapted to be coupled with power source 124. Adaptor 126 is then electrically coupled with controller 122 by suitable wiring. Controller 122 is capable of sending a signal to relay 128, such as a solid state relay or other switches known in the art, which is capable of sending signals to first and second valves 114, 116 for moving valves 114, 116 between the gas feeding and exhaust positions. Those of ordinary skill in the art will recognize that controller 122 is not limited to a digital controller and associated circuitry described above, but any type of controller capable of operating the outlet valve may be used in the invention.

In the exemplary embodiment, controller 122 also allows an operator to input the temperature or temperature range at which to maintain the deposition device 10, i.e., the desired operating temperature. To this end, controller 122 may include an input device, such as keypad 130, configured to permit an operator to input the desired operating temperature. Controller 122 may also include an output device, such as an LED display (not shown), for displaying the desired operating temperature to the operator.

In the exemplary embodiment, thermal control unit 66 further includes a temperature-sensing device 132 operatively coupled with controller 122 and adapted to communicate a temperature associated with deposition device 10 to controller 122. In this way, controller 122 can actuate first and second valves 114, 116 so as to keep the deposition device 10 at the desired operating temperature. For instance, housing 88 may include a temperature-sensing socket 134 that is coupled with controller 122 via suitable wiring. One end of a temperature-sensing device 132, such as a thermocouple, a thermister, a resistance temperature device, an infrared pyrometer or other known devices, may be coupled with socket 134 and the other end positioned to measure a temperature associated with the deposition device 10. The controller 122 may also be configured to display the measured temperature associated with deposition device 10 on the LED display.

In one instance, for example, the temperature-sensing device 132 may be coupled directly with the deposition device 10. The measured temperature is then the actual temperature of the deposition device 10. In another instance, the temperature-sensing device 132 may be located in the space 76 between the deposition device 10 and the inner enclosure wall 70. While the measured temperature may not be the actual temperature of the deposition device 10, the measured temperature is associated with and correlates with the actual temperature of deposition device 10. In yet another instance, the temperature-sensing device 132 may be coupled with a surrogate 136, such as a block, located within enclosure 64 but not in contract with deposition device 10. Surrogate 136 is configured to have thermal characteristics, i.e. thermally behave, in a manner substantially similar to the deposition device 10. For instance, surrogate 136 may be made of the same material as deposition device 10. In this way, the measured temperature of the surrogate 136 should be similar to the temperature of the deposition device 10. The non-contact methods described above, i.e., measuring the gas temperature or the surrogate temperature may be advantageous in that the enclosure 64 may be placed around a deposition device 10 quickly, conveniently, and without much assembly or disassembly. In any event, the temperature associated with the deposition device 10 may be used to estimate the actual temperature of the deposition device 10 and thereby control the temperature of the deposition device 10. Those of ordinary skill in the art will recognize other temperatures that may be associated with the deposition device 10 which may be used in the invention.

In use, the thermal control unit 66 described above, may be used to maintain the deposition device 10 at a desired operating temperature. To this end, an enclosure 64 is positioned around deposition device 10. The thermal control unit 66 is then coupled with enclosure 64 via tubing 110, 112. The temperature-sensing device 132 is positioned within enclosure 64 so as to measure a temperature associated with the deposition device 10. An operator would then input the desired operating temperature into controller 122 via keypad 130. The vortex tube 86 is then put into operation so as to produce cold and hot gas streams by coupling the vortex tube 86 with the pressurized gas supply 92. The actuation of first and second valves 114, 116 may be configured in several different ways. For instance, in an exemplary embodiment, the default position of first valve 114 is to be in the gas feeding position, thus porting cold gas to enclosure 64, and the default position of second valve 116 is to be in the exhaust position, thus porting hot gas to the environment outside enclosure 64. Thus, the default position is to port cold gas into the interior 68 of enclosure 64 without any hot gas. This particular configuration may be advantageous when the desired operating temperature is near room temperature or approximately 70° F.

If the measured temperature, taken by temperature-sensing device 132, is below the desired operating temperature, the controller 122 sends a signal to relay 128 and to first valve 114 to shut off the flow of cold gas to enclosure 64 by actuating first valve 114 to the exhaust position, thus porting the cold gas to the environment. At the same time, controller 122 sends a signal to relay 128 and to second valve 116 to turn on the flow of hot gas to enclosure 64 by actuating valve second 116 to the gas feeding position, thus porting hot gas to the enclosure 64. This would continue until the measured temperature associated with deposition device 10 went above the desired operating temperature. When this happens, the controller 122 sends a signal to relay 128 and second valve 116 to shut off the flow of hot gas to the enclosure 64 by actuating second valve 116 to the exhaust position. At the same time, controller 122 sends a signal to relay 128 and first valve 114 to turn on the flow of cold gas to enclosure 64 by actuating first valve 114 to the gas feeding position. These steps are repeated to maintain the deposition device 10 at the desired operating temperature as determined by measuring the associated temperature.

In the embodiment of the invention described above, either the cold gas is being ported to the enclosure 64 or the hot gas is being ported to the enclosure 64, never both the cold and hot gases together. As mentioned above, this configuration may be advantageous when the desired operating temperature is approximately 70° F. The invention, however, is not so limited as other configurations may be used. For instance, when the desired operating temperature is relatively high, a configuration that may be advantageous is to always port hot gas to enclosure 64 and then turn on cold gas (together with the hot gas) when the measured temperature is above the high desired operating temperature. Alternately, when the desired operating temperature is relatively low, a configuration that may be advantageous is to always port cold gas to enclosure 64 and turn on hot gas (together with the cold gas) when the measured temperature is below the low desired operating temperature. Another alternative, similar to that described above for the exemplary embodiment, is to have as the default the porting of hot gas to enclosure 64 and when the measured temperature gets above the desired operating temperature, to turn off the hot gas and turn on the cold gas (without the hot gas). When the measured temperature falls below the desired operating temperature, to turn off the cold gas and turn on the hot gas (without the cold gas). Thus, as one of ordinary skill in the art will recognize, there are many configurations for porting cold and/or hot gas to enclosure 64 within the scope of the invention.

The thermal control unit 66 may further include a number of convention features that provide a safety and/or convenience feature for the user. For instance, thermal control unit 66 may include a power switch 138 coupled intermediate the electrical adaptor 126 and controller 122. Because the controller 122 and first and second valves 114, 116 may be electrically actuated solenoid valves, an operator first has to turn the thermal control unit 66 on before effectively using it to control a material deposition process. The thermal control unit 66 may further include a manual valve 140 so that the vortex tube 86 does not necessarily operate when coupled with pressurized gas supply 92. Thus, an operator must intentionally turn valve 140 on to cause vortex tube 86 to generate cold and hot gas streams.

In another embodiment of the invention, similar in concept to the manual valve 140 above, the inlet 90 to vortex tube 86 may be coupled with an inlet valve 142, such as in tubing 96 between inlet 90 and gas supply port 94, which is operable to vary the flow of gas delivered to vortex tube 86. The inlet valve 142 may be operatively coupled with controller 122 so that controller 122 may actuate valve 142 so as to control the flow of gas to vortex tube 86. In essence, inlet valve 142 turns the vortex tube 86 on and off. When inlet valve 142 is on, gas may flow to vortex tube 86 and cold and hot gas streams are generated. When inlet valve 142 is off, gas is prevented from flowing to vortex tube 86 and no gas streams are generated. Inlet valve 142 may be advantageous, for example, when very little thermal control needs to be performed to keep the deposition device 10 at the desired operating temperature. Without inlet valve 142, the vortex tube 86 would always be generating cold and hot gas streams and perhaps causing needless cycling of first and second valves 114, 116 and their associated gas streams. With inlet valve 142, controller 122 can essentially turn off the vortex tube 86 when no thermal control needs to be performed.

The invention as shown and described herein provides a number of advantages over existing thermal control systems. For instance, the invention provides an enclosure 64 that primarily encloses or encapsulates the deposition device 10 itself instead of a whole machine or even an entire building, as with many previous thermal control systems. Thus, the temperature control is localized, which not only makes the invention more cost effective, but also allows for quick thermal responses that can keep the deposition device 10 within a close tolerance to the desired operating temperature, such as within +/-0.5°F. The vortex tube based thermal control unit 66 is a small, compact, modular unit which may be used with a wide range of deposition devices 10, such as dispensing valve 18 and dispensing syringe 20, and over a wide range of desired operating temperatures. For instance the deposition of many assembly fluids, such as, but not limited to, greases, lubricants, inks, sealants, epoxies, adhesives, solder pastes, cyanoacrylates, under-fills, encapsulants, thermal compounds, and many other liquid and semi-liquid materials have ideal deposition temperatures between approximately 50-100°F. Although not limited to such a temperature range, the invention easily accommodates such a temperature range. In short, the thermal control system 62 provides heating and cooling of a deposition device 10 in an enclosure 64 having a minimized amount of space using a thermal control unit 66 that has few moving parts, is inexpensive to operate and maintain, and is extremely effective at keeping the deposition device 10 at a desired operating temperature.

While the present invention has been illustrated by a description of various preferred embodiments and while these embodiments have been described in some detail, it is not the intention of the Applicants to restrict or in any way limit the scope of the appended claims to such detail. Additional advantages and modifications will readily appear to those skilled in the art. The various features of the invention may be used alone or in numerous combinations depending on the needs and preferences of the user.

## Claims

1. An apparatus for depositing a material onto a substrate under thermally controlled conditions, comprising:
an enclosure defining an interior and having an opening;
a deposition device having an orifice and capable of depositing the material onto the substrate, said deposition device positioned within said interior, said opening adapted to allow said orifice to communicate with an environment outside said enclosure; and
a thermal control unit operatively coupled with said enclosure to provide heating and cooling to said interior, said thermal control unit including a vortex tube adapted to generate cold and hot gas streams from a pressurized gas supply, said vortex tube having an inlet adapted to be coupled with the pressurized gas supply, a cold gas outlet in fluid communication with said interior and adapted to deliver the cold gas thereto, and a hot gas outlet in fluid communication with said interior and adapted to deliver the hot gas thereto, the cold and hot gases from said vortex tube adapted to control the temperature of said deposition device.

2. The apparatus of claim 1, wherein said deposition device further comprises a dispensing device operative to discharge a liquid.

3. The apparatus of claim 2, wherein said dispensing device is selected from the group consisting of a dispensing valve and a dispensing syringe.

4. The apparatus of claim 1, further comprising:
an outlet valve coupled with at least one of said cold and hot gas outlets, said outlet valve operable to vary the flow of gas delivered to said interior through said at least one of said cold and hot gas outlets.

5. The apparatus of claim 1, further comprising:
a first outlet valve coupled with said cold gas outlet and operable to vary the flow of cold gas delivered to said interior; and
a second outlet valve coupled with said hot gas outlet and operable to vary the flow of hot gas delivered to said interior.

6. The apparatus of claim 5, wherein said first and second outlet valves are solenoid valves each having a gas feeding position and an exhaust position,
said cold gas outlet in fluid communication with said interior when said first outlet valve is in said gas feeding position, said cold gas outlet in fluid communication with the environment outside said enclosure when said first outlet valve is in said exhaust position, and
said hot gas outlet in fluid communication with said interior when said second outlet valve is in said gas feeding position, said hot gas outlet in fluid communication with the environment outside said enclosure when said second outlet valve is in said exhaust position.

7. The apparatus of claim 1, further comprising:
a controller operatively coupled with said outlet valve to actuate said outlet valve so as to control the flow of gas to said interior through said at least one of said cold and hot gas outlets.

8. The apparatus of claim 7, further comprising:
an inlet valve coupled with said inlet and operable to vary the flow of gas delivered to said vortex tube, said controller operatively coupled with said inlet valve to actuate said inlet valve so as to control the flow of gas to said vortex tube.

9. The apparatus of claim 7, further comprising:
a temperature-sensing device operatively coupled with said controller and adapted to communicate a temperature associated with said deposition device to said controller.

10. The apparatus of claim 9, wherein said temperature-sensing device is selected from the group consisting of a thermocouple, a thermister, a resistance temperature device, and an infrared pyrometer.

11. A thermal control system for a deposition device having an orifice and capable of depositing a material onto a substrate, comprising:
an enclosure defining an interior for containing the deposition device and having an opening adapted to allow the orifice to communicate with an environment outside said enclosure; and
a thermal control unit operatively coupled with said enclosure to provide heating and cooling to said interior, said thermal control unit including a vortex tube adapted to generate cold and hot gas streams from a pressurized gas supply, said vortex tube having an inlet adapted to be coupled with the pressurized gas supply, a cold gas outlet in fluid communication with said interior and adapted to deliver the cold gas thereto, and a hot gas outlet in fluid communication with said interior and adapted to deliver the hot gas thereto, the cold and hot gases from said vortex tube adapted to control the temperature of the deposition device.

12. The thermal control system of claim 11, further comprising:
an outlet valve coupled with at least one of said cold and hot gas outlets, said outlet valve operable to vary the flow of gas delivered to said interior through said at least one of said cold and hot gas outlets.

13. The thermal control system of claim 11, further comprising:
a first outlet valve coupled with said cold gas outlet and operable to vary the flow of cold gas delivered to said interior; and
a second outlet valve coupled with said hot gas outlet and operable to vary the flow of hot gas delivered to said interior.

14. The thermal control system of claim 13, wherein said first and second outlet valves are solenoid valves each having a gas feeding position and an exhaust position,
said cold gas outlet in fluid communication with said interior when said first outlet valve is in said gas feeding position, said cold gas outlet in fluid communication with the environment outside said enclosure when said first outlet valve is in said exhaust position, and
said hot gas outlet in fluid communication with said interior when said second outlet valve is in said gas feeding position, said hot gas outlet in fluid communication with the environment outside said enclosure when said second outlet valve is in said exhaust position.

15. The thermal control system of claim 12, further comprising:
a controller operatively coupled with said outlet valve to actuate said outlet valve so as to control the flow of gas to said interior through said at least one of said cold and hot gas outlets.

16. The thermal control system of claim 15, further comprising:
an inlet valve coupled with said inlet and operable to vary the flow of gas delivered to said vortex tube, said controller operatively coupled with said inlet valve to actuate said inlet valve so as to control the flow of gas to said vortex tube.

17. The thermal control system of claim 15, further comprising:
a temperature-sensing device operatively coupled with said controller and adapted to communicate a temperature associated with the deposition device to said controller.

18. The thermal control system of claim 17, wherein said temperature-sensing device is selected from the group consisting of a thermocouple, a thermister, a resistance temperature device, and an infrared pyrometer.

19. A thermal control unit adapted to provide heating and cooling to an enclosure containing a deposition device, comprising:
a vortex tube adapted to generate cold and hot gas streams from a pressurized gas supply, said vortex tube having an inlet adapted to be coupled with the pressurized gas supply, a cold gas outlet adapted to be in fluid communication with the enclosure and adapted to deliver the cold gas thereto, and a hot gas outlet adapted to be in fluid communication with the enclosure and adapted to deliver the hot gas thereto, the cold and hot gases from said vortex tube adapted to control the temperature of the deposition device;
an outlet valve coupled with at least one of said cold and hot gas outlets, said outlet valve operable to vary the flow of gas delivered to the enclosure through said at least one of said cold and hot gas outlets;
a controller operatively coupled with said outlet valve and adapted to actuate said outlet valve so as to control the flow of gas to the enclosure through said at least one of said cold and hot gas outlets; and
a temperature-sensing device operatively coupled with said controller and adapted to communicate a temperature associated with the deposition device to said controller.

20. A method of thermally controlling a material deposition process using a vortex tube, the material deposition process using an enclosure defining an interior, and a deposition device positioned within the interior and capable of depositing a material onto a substrate, the method comprising:
measuring a temperature associated with the deposition device;
delivering at least one of a cold and hot gas from the vortex tube to the interior based on the measured temperature; and
depositing a material from the deposition device onto the substrate.

21. The method of claim 20, further comprising:
storing a desired operating temperature for the deposition device in a controller; and
delivering at least one of the cold and hot gases from the vortex tube to the interior to maintain the deposition device substantially at the desired operating temperature.

22. The method of claim 21, further comprising:
delivering one of the cold and hot gases to the interior; and
delivering the other one of the cold and hot gases to the interior only when the measured temperature associated with the deposition device is not substantially equal to the desired operating temperature.

23. The method of claim 22, further comprising:
turning off the flow of the one of the cold and hot gases to the interior when the other one of the cold and hot gases is being delivered to the interior.

24. The method of claim 21, further comprising:
delivering the cold gas to the interior;
turning off the flow of cold gas to the interior when the measured temperature associated with the deposition device is below the desired operating temperature;
turning on the flow of hot gas to the interior; and
turning off the flow of hot gas to the interior when the measured temperature associated with the deposition device is above the desired operating temperature.
